# EUROPEAN PATENT SPECIFICATION

(11) **EP 2 793 253 B1**
(45) Date of publication and mention of the grant of the patent: **13.09.2017**
(21) Application number: 12857614.7
(22) Date of filing: 04.12.2012
(51) Int. Cl.: H01L 31/0236

(54) **METHOD FOR MANUFACTURING A SILICON SUBSTRATE HAVING TEXTURED SURFACE**
HERSTELLUNGSVERFAHREN FÜR EIN SILIZIUMSUBSTRAT MIT EINER TEXTURIERTEN OBERFLÄCHE
PROCÉDÉ DE FABRICATION D'UN SUBSTRAT DE SILICIUM AYANT UNE SURFACE TEXTURÉE

(30) Priority: 15.12.2011 JP 2011274306
(43) Date of publication of application: 22.10.2014
(73) Proprietor: Panasonic Intellectual Property Management Co., Ltd., Osaka-shi, Osaka 540-6207 (JP)
(72) Inventor: YAMAGUCHI, Naoshi, Osaka 540-6207 (JP); TANABE, Hiroshi, Osaka 540-6207 (JP); TANIGUCHI, Yasushi, Osaka 540-6207 (JP); NAKAYAMA, Ichiro, Osaka 540-6207 (JP)
(74) Representative: Schwabe - Sandmair - Marx
(86) International application number: PCT/JP2012/007767
(87) International publication number: WO 2013/088671

(56) References cited:
- WO-A1-2012/132433
- JP-A- H10 163 513
- JP-A- H10 313 128
- JP-A- H11 265 877
- JP-A- 2008 124 413
- JP-A- 2008 198 629
- US-A1- 2005 126 627

## Description

### Technical Field

The present invention relates to a method for manufacturing a silicon substrate having a textured surface.

### Background Art

In a silicon solar cell (photoelectric conversion element), unevenness called a texture is formed on a light-receiving surface of a silicon substrate in order to reduce the reflection of incident light and prevent the light entered the silicon substrate from leaving the silicon substrate. The surface of the silicon substrate is generally textured by wet etching using an alkaline (KOH) solution as an etchant (for example, see PTL1). More specifically, a technique for forming a textured surface having a specific surface roughness by wet etching has been disclosed (see PTL2).

Texturing by wet etching is generally high in the running cost for chemical processing of the solution after use. In addition, the waste solution brings concerns on environmental load. Wet etching also requires a cleaning process using hydrogen fluoride and a thermal process as post-processes. Accordingly, with wet etching, not only the surface of the silicon substrate may be contaminated, but also there is disadvantage with regard to cost.

In addition, only a silicon substrate having plane orientation (100) can be textured by wet etching. For this reason, a surface of a silicon substrate having another plane orientation cannot be textured by wet etching.

Meanwhile, another method for texturing a surface of a silicon substrate by dry etching has been presented. As the first method for dry etching, a method referred to as reactive ion etching by plasma, using an etching gas containing oxygen gas, nitrogen trifluoride gas, and chlorine gas has been known (see PTL3, for example). In addition, as a method for forming a trench by etching a silicon substrate, a technique for performing reactive ion etching by plasma, using a silicon oxide film as a mask and a gas containing chlorine gas and oxygen gas has been presented (see PTL4).

As the second method for dry etching, chemical dry etching on a surface of a silicon substrate is performed by introducing an etching gas containing one of ClF₃, XeF₂,

BrF₃, and BrF₅ into a reactive chamber under the atmospheric pressure has been proposed (for example, see PTL5).

Another known method is to form a texture on a silicon substrate by performing chemical dry etching using an etching gas such as chlorine gas and subsequently performing wet etching (see PTL6).

### Citation List

### Patent Literature

PTL1
   Japanese Patent Application Laid-Open No. 2000-150937
PTL2
   Japanese Patent Application Laid-Open No. 2003-069061
PTL3
   Japanese Patent Application Laid-Open No. 2010-21196
PTL4
   Japanese Patent Application Laid-Open No. 9-007996
PTL5
   Japanese Patent Application Laid-Open No. 10-313128
PTL6
   Japanese Patent Application Laid-Open No. 2005-150614

### Summary of Invention

### Technical Problem

As described above, wet etching has problems related to productivity. With regard to dry etching, there is room for examination on controlling the shape of the textured surface.

For example, in reactive ion etching by plasma, a textured surface having projections with the height of approximately 0.1 to 0.8 µm is formed. However, with the reactive ion etching by plasma, a textured surface with a size as large as the textured surface formed by wet etching is not obtained. Furthermore, with the first method, the silicon substrate may be damaged by plasma, reducing the characteristics for a solar cell.

Furthermore, in chemical dry etching using an etching gas, a chemical reaction with the etching gas and the silicon, which is an exothermic reaction, increases the temperature of the silicon substrate. The increase in the temperature of the silicon substrate may inhibit anisotropic etching. As a result, a desired textured structure may not be obtained. Furthermore, there is room for examination on the composition of an etching gas for obtaining an appropriate textured structure.

It is an object of the present invention to form a desired textured surface on a silicon substrate by chemical dry etching, and to provide a solar cell including the silicon substrate having a desired textured surface.

The following examples are disclosed.
[1] A silicon substrate having a plane orientation (111) and including a textured surface on which a textured structure is formed, in which: a plurality of projections each having three faces are formed on the textured surface, the three faces being a (100) plane, a (010) plane, and a (001) plane; and a height of the projections is in a range greater than 1.5 µm and smaller than or equal to 10 µm.
[2] The silicon substrate according to [1], in which a length of a generatrix of the projection is in a range from 1 to 10 µm.
[3] A solar cell including the silicon substrate according to [1] or [2], in which the solar cell includes the textured surface as a light-receiving surface.

The present invention relates to a method for manufacturing a silicon substrate having a textured surface described below. A method for manufacturing a silicon substrate, comprising: a first step of providing a silicon substrate having a plane orientation; and a second step of forming a textured surface by exposing a surface of the silicon substrate to an etching gas containing ClF₃ gas and 0₂ gas, where a volume ratio of 0₂ gas to ClF₃ gas (0₂/ClF₃) is greater than 2 and smaller than 6, the textured surface including a plurality of projections each having three faces, wherein the three faces are a (100) plane, a (010) plane, and a (001) plane. The surface of the silicon substrate may be exposed to the etching gas under an atmospheric pressure. The second step may include: exposing the surface of the silicon substrate to the etching gas having a volume ratio of 0₂ gas to ClF₃ gas (0₂/ClF₃) greater than or equal to 0 and smaller than or equal to 4; and forming the textured surface by exposing the surface of the silicon substrate to the etching gas having the volume ratio of 0₂ gas to ClF₃ gas (0₂/ClF₃) greater than 2 and smaller than 6. A plurality of projections each having three faces may be formed on the textured surface, wherein a height of the projections is in a range greater than 1.5 µm and smaller than or equal to 10 µm.

### Advantageous Effects of Invention

The silicon substrate includes a textured surface having a plurality of projections each with three faces. The height of the projection is greater than 1.5 µm and smaller than or equal to 10 µm. The present invention is capable of providing a solar cell including a silicon substrate having a unique textured surface and a textured surface having projections with the same size as projections on the textured surface obtained by the conventional wet etching.

### Brief Description of Drawings

FIG. 1 is a micrograph (magnification: x3,000, a halftone image on a display) of a textured surface of a silicon substrate according to Example 1 of the present invention;
FIGS. 2A to 2C are micrographs (magnification: x3,000, halftone images on a display) of textured surfaces of a silicon substrate according to Example 1 of the present invention during a manufacturing process;
FIGS. 3A and 3B are micrographs (magnification: x3,000, halftone images on a display) of a textured surface and a cross section of a silicon substrate according to Example 2 of the present invention when a first etching gas supply ends;
FIGS. 4A and 4B are micrographs (magnification: x3,000, halftone images on a display) of a textured surface and a cross section of a silicon substrate according to Example 2 of the present invention when a second etching gas supply ends;
FIG. 5 is a micrograph (magnification: x3,000, a halftone image on a display) of a textured surface of a silicon substrate according to Comparative Example 1 of the present invention;
FIG. 6 is a micrograph (magnification: x10,000, a halftone image on a display) of a textured surface of a silicon substrate according to Comparative Example 2 of the present invention;
FIG. 7 is a micrograph (magnification: x3,000, a halftone image on a display) of a textured surface of a silicon substrate according to Comparative Example 3 of the present invention;
FIG. 8 is a micrograph of a textured surface of a silicon substrate having a plurality of triangular pyramids;
FIGS. 9A to 9C are diagrams for describing the height of projections each having three faces on the textured surface;
FIGS. 10A to 10C are diagrams schematically illustrating a cross section of a textured surface according to the present invention along the manufacturing process;
FIGS. 11A and 11B are diagrams schematically illustrating an example of a texturing apparatus used for manufacturing a silicon substrate according to the present invention; and FIG. 12 is a graph representing optical reflectance of textured surfaces.

### [1. Silicon Substrate Having a Textured Surface]

The silicon substrate has a textured surface on a surface of the silicon substrate.

The silicon substrate is a silicon substrate having a plane orientation (111). The silicon substrate is a substrate made of single-crystal silicon. The silicon substrate may be a substrate made of silicon doped with a p-type impurity, a substrate made of silicon doped with an n-type impurity, or a substrate made of intrinsic silicon. The silicon substrate may be a semiconductor wafer, or a semiconductor layer stacked on another substrate. For example, a silicon substrate for a solar cell is generally a silicon substrate doped with a p-type impurity.

The thickness of the silicon substrate may be smaller than or equal to 150 µm. The thickness of the silicon substrate is preferably smaller than or equal to 100 µm, and more preferably smaller than or equal to 50 µm. The lower limit of the thickness of the silicon substrate is not particularly limited as long as the strength necessary for the substrate is maintained. Usually, the lower limit is greater than or equal to 10 µm.

The textured surface refers to a part of a surface of a silicon substrate where a texture is formed. The textured surface is a surface with a low reflectance as well. The low reflectance surface refers to a surface having a reflectance smaller than or equal to 20%, preferably smaller than or equal to 10%, and more preferably substantially 0%, where the reflectance is determined based on the reflectance of light on the mirror surface for the light having a wavelength of 0.5 to 1.0 µm as 100%. The reflectance can be measured using an integrating sphere spectrophotometer.

The absorptive power of the textured surface (wavelength range of 0.5 to 1.0 µm) is preferably 80% or more, and more preferably 85% or more. The absorptive power can be calculated by the integrating sphere spectrophotometer using the formula "absorptive power (%) = 100 × {intensity of incident light - (intensity of reflected light + intensity of transmitted light)} / intensity of incident light."

The textured surface may be the entire surface of the silicon substrate or a part of the surface of the silicon substrate. For example, when the silicon substrate having the textured surface according to the present invention is used for a solar cell, it is preferable that a region for a surface electrode (including a connector electrode, a bar electrode, a grid electrode, and others) provided on the light-receiving surface is a flat surface, not a textured surface.

The textured surface includes a plurality of projections each having three faces. It is preferable that the plurality of projections is densely formed on the textured surface. The projections having the three faces are typically triangular pyramid projections. The triangular pyramid is a conic solid having a triangular bottom surface and an apex. The triangular pyramid is preferably close to an equilateral triangular pyramid. However, the triangular pyramid may not have to be precisely equilateral-triangular.

The three faces of the projection are a (100) plane, a (010) plane, and a (001) plane. Based on the etching method according to the present invention, the three faces can be exposed by performing crystal anisotropic etching on a silicon substrate having a plane orientation (111).

The textured surface may include a projection in a shape other than the projection having three faces. Another shape for the projection includes a square pyramid or a circular cone, for example.

The density of the projections on the textured surface is preferably 10 to 1,000 per unit area (100 µm²). The ratio of the number of projections having three faces to the total number of projections on the textured surface is preferably 50 to 100%, and is more preferably 90 to 100%. The density of the projections and the ratio of the projections having three faces can be calculated by capturing an image of the textured surface by an electron microscope, and counting the number of vertices in one visual field.

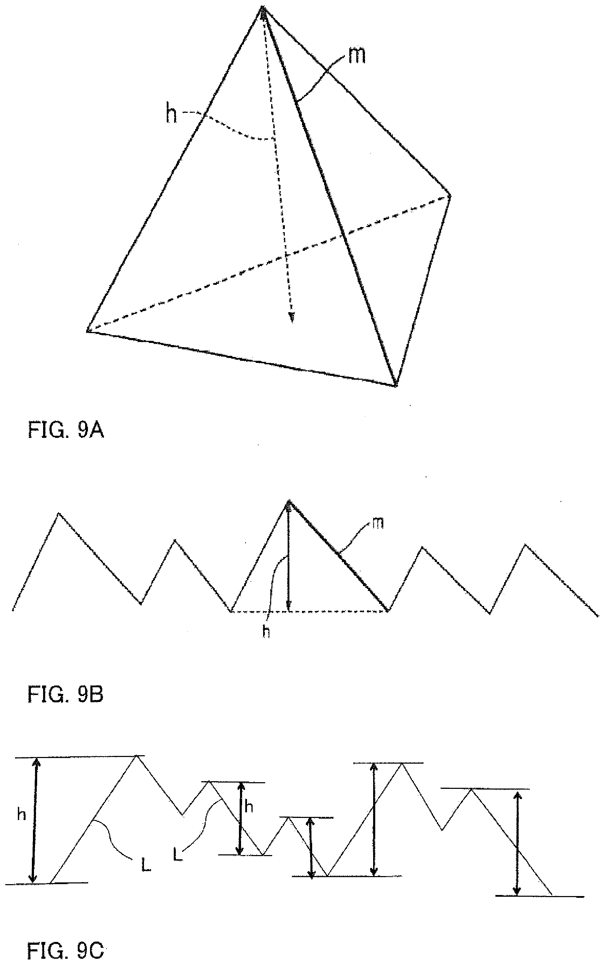

The height h of a projection having three faces refers to a difference in height between the apex or the top face of the projection and the lower end of the generatrixes of the projection (see FIGS. 9A and 9B). Usually, a plurality of the generatrixes of a projection are not the same in length, and thus in a cross section including the longest generatrix among the generatrixes of the projection, the difference in height between the apex or the top face of the projection and the lower end of the generatrix is referred to as the height h of the projection.

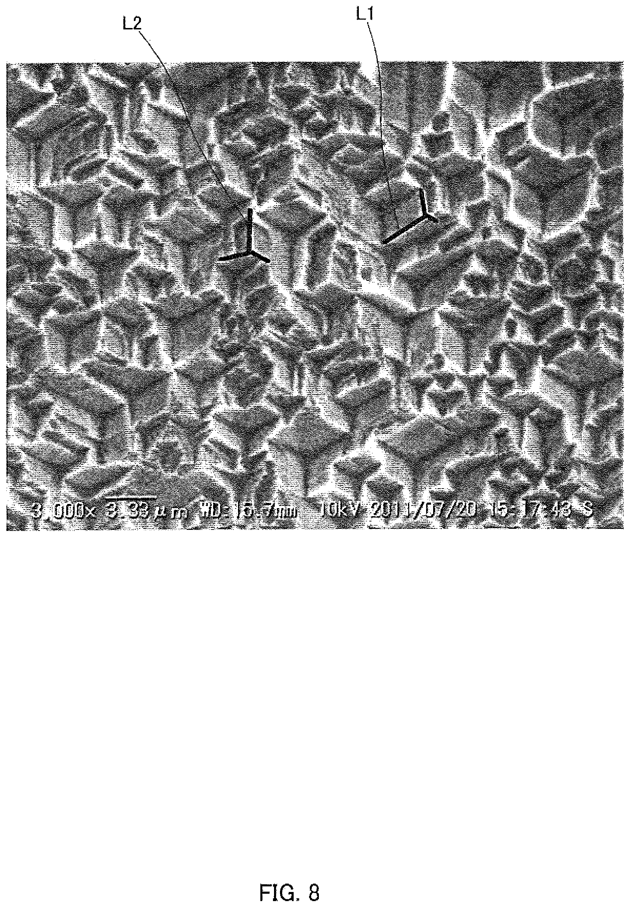

For example, as illustrated in FIG. 8, when the projection is a triangular pyramid, the difference in height between the apex of the triangular pyramid and the lower end of the ridge is determined as the height h of the projection, as illustrated in FIGS. 9A and 9B. More specifically, in a cross section including the ridge with the largest difference in height among the three ridges (generatrixes) (see L1 or L2 in FIG. 8), the difference in height between the apex of the projection and the lower end of the ridge is determined as the height h of the projection (see FIG. 9C).

The height h of the projection is greater than 1.5 µm and smaller than or equal to 10 µm, and preferably greater than 1.5 µm and smaller than or equal to 5.0 µm. The length of the generatrix m of the projection (see FIG. 8) is preferably 1 to 10 µm, and more preferably 1.5 to 5.0 µm.

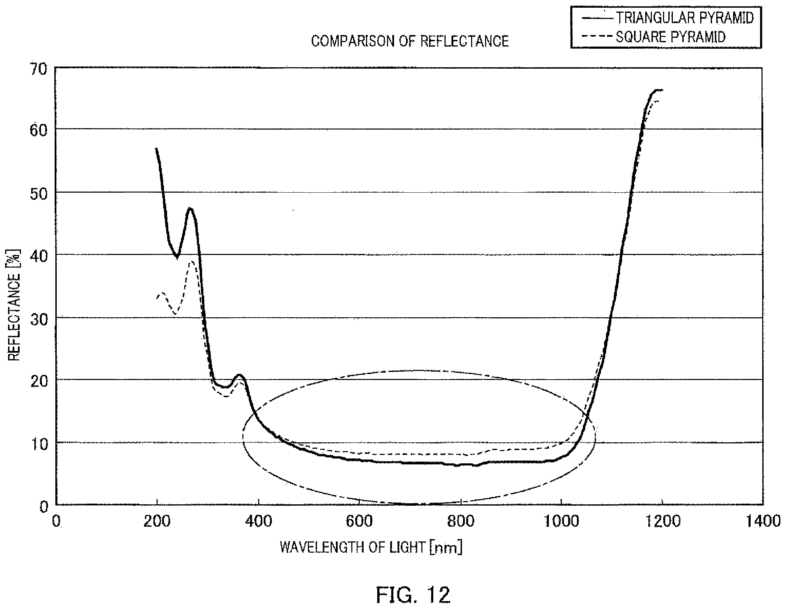

When the height h of a projection having three faces is greater than 1.5 µm and smaller than or equal to 5.0 µm, it is easy to suppress the reflection of light on the textured surface, and the silicon substrate easily absorbs the light. FIG. 12 illustrates an optical reflectance on textured surface α of the silicon substrate (solid line) having a plurality of projections with three faces (triangular pyramid) where the height h of the projection is greater than 1.5 µm and smaller than or equal to 5.0 µm, and an optical reflectance on textured surface β of the silicon substrate (dotted line) having a plurality of projections with four faces (square pyramid) where the height of the projection is greater than or equal to 5 µm and smaller than or equal to 20 µm. The optical reflectance is measured using an integrating sphere spectrophotometer. As illustrated in FIG. 12, the reflectance of light in a wavelength of approximately 400 nm to 1100 nm which is a range of light used for a regular solar cell on textured surface α is lower than the reflectance on textured surface β. Textured surface β is formed by the conventional wet etching (etching using an alkali solution as an etchant).

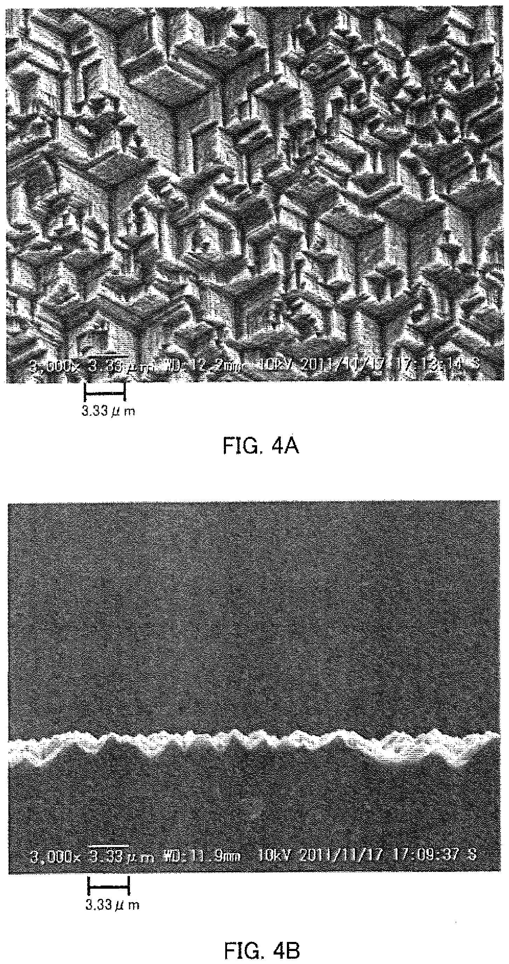

Fine unevenness may be formed on three faces of a projection having three faces. For example, the three faces may be formed in steps or multiple layers (see FIG. 4A). With this fine unevenness, the reflectance of light on the textured surface can be reduced further.

The height of the projection having three faces may be approximately the same as the height of the projection formed by the conventional wet etching. However, a textured surface including the projections having three faces with the height which are densely formed has not been provided. The unique textured surface is expected to include optical characteristics that have not been provided before.

### Description of Embodiments

### [2. Method for Manufacturing a Silicon Substrate Having a Textured Surface]

The method for manufacturing a silicon substrate according to the present invention includes a first step of providing a silicon substrate having a plane orientation (111) and a second step of exposing a surface of the silicon substrate to an etching gas.

The silicon substrate having the plane orientation (111) used in the first process can be purchased on the market, for example.

In the second process, the surface of the silicon substrate is exposed to an etching gas, and the textured surface is formed after a porous structure is formed. The etching gas contains ClF₃ gas and O₂ gas. The porous structure is a surface structure of a silicon substrate composed of fine tubes in an ant-colony shape. Note that, the term "ant-colony shape" refers to a shape including an opening on the surface of the substrate leading to a hole irregularly extending toward the inside of the substrate. The hole may branch out while extending irregularly, or may intersect with another hole.

In the second process, the following reactions occur on the surface of the silicon substrate.

3Si + 4ClF₃ → 3SiF4 + 2Cl₂ (1)

Si + O₂ → SiO₂ (2)

ClF₃ molecules in ClF₃ gas in the etching gas generate a volatile fluorine compound SiF₄ by reaction with silicon on the surface of the silicon substrate (reaction (1)). With this process, the surface of the silicon substrate is etched. O₂ molecules in O₂ gas in the etching gas generate silicon oxide SiO₂ by reaction with silicon on the surface of the silicon substrate (reaction (2)). The reactions (1) and (2) are exothermic reactions. Reaction (1) exhibits high reactivity when the temperature of the substrate is low (for example, at room temperature or higher). Reaction (2) exhibits higher reactivity when the temperature of the substrate is high to extent certain level (for example, 80°C or higher). Reaction (1) generally exhibits higher reactivity than reaction (2).

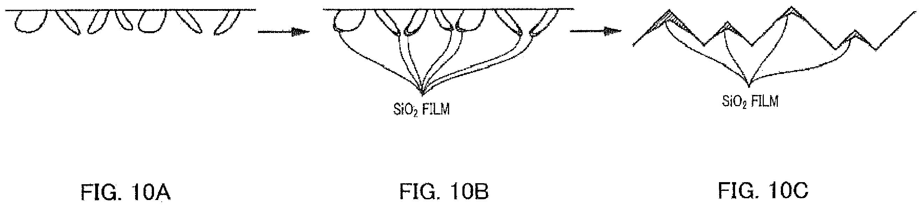

Reaction (1) proceeds regardless of plane orientation. Accordingly, in the second process, the porous structure is formed on the surface of the silicon substrate (see FIG. 10A).

In contrast, by reaction (2), the surface of the silicon substrate having the plane orientation (111) is more likely to be oxidized than another surface having a different plane orientation. Accordingly, in the second process, as illustrated in FIG. 10B, SiO₂ films are selectively formed, for example, on the bottoms of the holes of the porous structure formed by ClF₃ gas, among the part facing plane orientation (111). The SiO₂ films are resistant to erosion by ClF₃ gas.

It is considered that the SiO₂ films formed on the silicon substrate compose inflection points, and the part of the silicon substrate other than the inflection points are etched by ClF₃ gas (see FIG. 10C). Accordingly, by adjusting the ratio of ClF₃ gas and O₂ gas in the etching gas for balancing the etching by ClF₃ gas and forming the SiO₂ films, the unique textured surface according to the present invention can be formed.

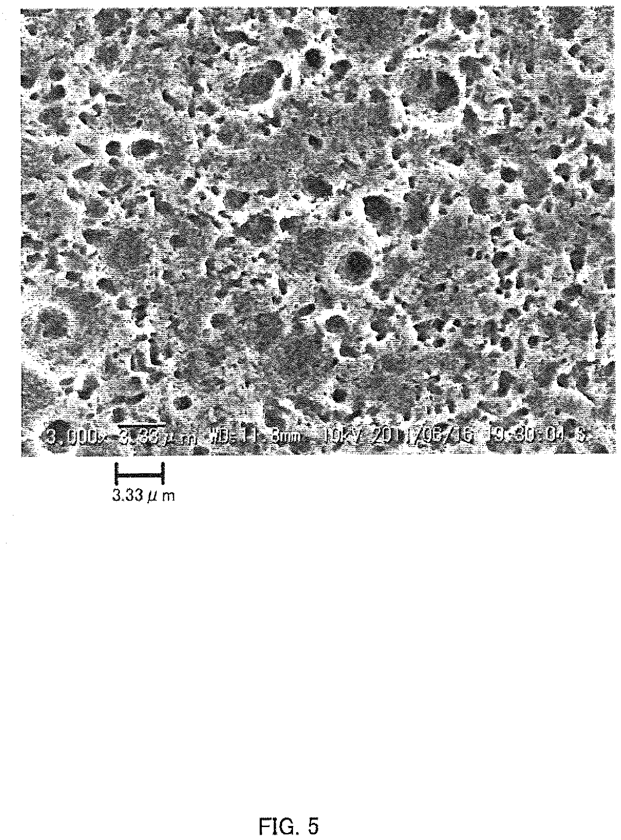

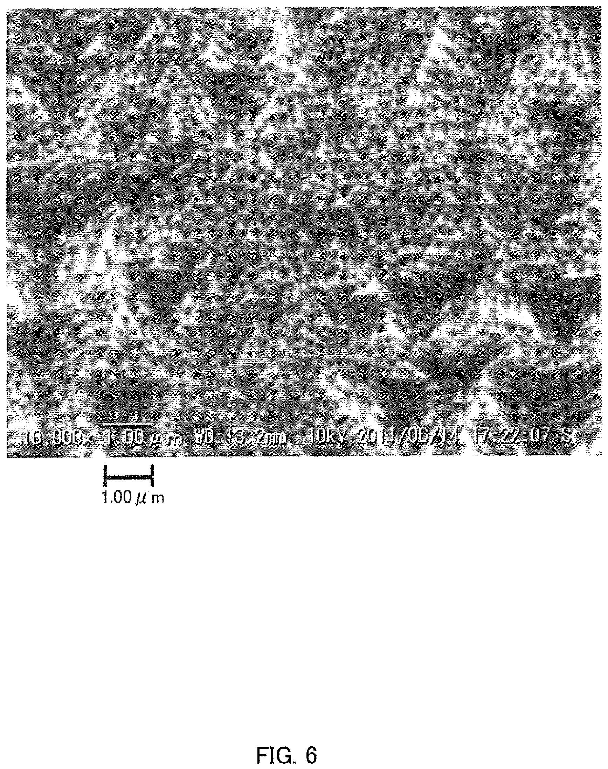

The volume ratio of O₂ gas to ClF₃ gas (O₂/ClF₃) in the etching gas is less than 6. When the volume ratio is less than 6, a textured surface having projections with the height greater than 1.5 µm and smaller than or equal to 10 µm is obtained. When the volume ratio is too large, the height of the projections of the textured surface becomes too low (see FIG. 6). When the volume ratio is too small, only the porous structure may be formed, not resulting in the textured surface (see FIG. 5). The volume ratio is greater than 2 and smaller than 6, and more preferably, 2.5 to 4.5 so as to obtain a textured surface including projections with a desired height.

The amount of etching gas to which the silicon substrate is exposed can be determined according to the size of the silicon substrate and a configuration of a texturing apparatus, such that the etching gas having the volume ratio described above is supplied to the surface of the silicon substrate. For example, when forming a textured structure in a region of 125 × 125 mm on the surface of a silicon substrate, the total amount of ClF₃ gas and O₂ gas in the etching gas used for exposing the surface of the silicon substrate is preferably 50 to 5,000 sccm, and more preferably 2,000 to 5,000 sccm. Here, "seem" refers to a flow rate (cc/min (cm³/min)) in standard conditions (20°C, 1 atm.).

The volume ratio (O₂/ClF₃) may be maintained at a constant level in the range described above through the second process, or may be changed during the second process. For example, the second step may include a step for forming a porous structure by exposing the surface of the silicon substrate to the first etching gas, and a step for forming a textured surface by exposing the surface of the silicon substrate in which the porous structure is formed to the second etching gas.

The volume ratio of O₂ gas to ClF₃ gas (O₂/ClF₃) in the first etching gas is preferably greater than or equal to 0 and smaller than or equal to 4 (0 to 4), and more preferably 0 to 1. The volume ratio in the first etching gas can be set in order to form the porous structure or in order to prevent a runaway of the reaction for forming the porous structure.

The volume ratio of O₂ gas to ClF₃ gas in the second etching gas (O₂/ClF₃) is greater than 2 and smaller than 6, and more preferably 2.5 to 4.5. The volume ratio in the second etching gas can be set in order to obtain the projections having a height within the range described above.

It is preferable that the etching gas further contains an inert gas. The inert gas refers to a gas that does not react with silicon. The inert gas includes nitrogen gas, argon gas, and helium gas, for example. The inert gas may be a mixed gas of two or more gases.

The content of inert gas in the etching gas is preferably 0 to 400 times, more preferably 1 to 40 times, of the total volume of ClF₃ gas and O₂ gas in volume ratio. The content may be set in order to adjust and control the reaction speeds of reaction (1) and reaction (2).

The exposure of the silicon substrate to the etching gas maybe performed under a reduced pressure or high pressure. However, the exposure is preferably performed under the atmospheric pressure (for example, a pressure ±15% of the atmospheric pressure).

The silicon substrate is manufactured by an apparatus capable of housing the silicon substrate in an airtight space and supplying an etching gas of a desired amount on the surface of the silicon substrate in the airtight space.

The manufacturing method according to the present invention may include an optional process as long as the effect of the present invention can be achieved. As the optional process, for example, a process for adjusting a temperature of a silicon substrate, and a process for removing the etching gas or a decomposed matter of the etching gas remaining on the silicon substrate after the second process may be included. For example, the process for removing the decomposed matter can be performed by placing the silicon substrate under a hydrogen gas atmosphere. In the process, the residual fluoride component on the surface of the silicon substrate is removed.

### [3. Solar Cell]

The solar cell includes the silicon substrate and has the textured surface as a light-receiving surface.

For example, the solar cell may be configured by forming an emitter layer on the textured surface of the silicon substrate so as to form a p-n junction, providing a surface electrode on the emitter layer formed, and providing a back surface electrode on the non-light receiving surface. Alternatively, the solar cell may be configured by providing a surface electrode on the light-receiving surface which is the textured surface of the silicon substrate, forming a p-n junction on the non-light receiving surface, and further providing a back electrode.

For example, when a textured surface is formed on a p-type silicon substrate, a p-n junction can be formed by heating the textured surface under a phosphorus oxychloride atmosphere so as to form an n-type emitter layer on the textured surface.

An anti-reflection layer may be provided between the emitter layer and the surface electrode. By providing the anti-reflection layer, the reflectance of the sunlight can be reduced further, further improving the photoelectric conversion rate of the solar cell. The anti-reflection layer includes, for example, a silicon nitride film, a silicon oxide film, and a titanium oxide film.

### [Examples]

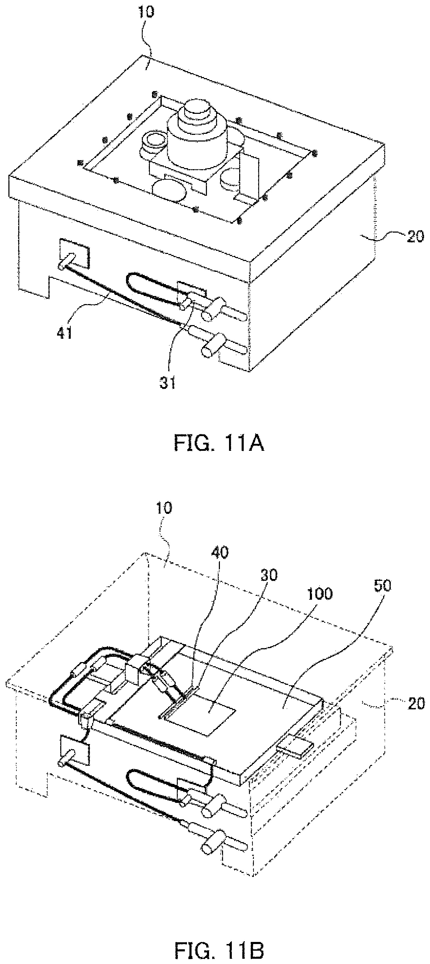

FIGS. 11A and 11B illustrate an overview of a texturing apparatus for texturing a silicon substrate. FIG. 11A is an external perspective view of texturing apparatus 10, and FIG. 11B is a perspective view of texturing apparatus 10 seeing chamber 20 through. Texturing apparatus 10 illustrated in FIGS. 11A and 11B includes, in chamber 20, nozzles 30 and 40 for exposing silicon substrate 100 to the etching gas and stage 50 for placing silicon substrate 100 thereon. Nozzle 30 is connected to etching gas supply pipe 31. Nozzle 40 is connected to etching gas supply pipe 41. Nozzle 40 supplies a gas for processing, for example. The gas for processing is an inert gas such as N₂ gas for cooling silicon substrate 100 and H₂ gas for removing a decomposed matter on silicon substrate 100.

### [Example 1]

Silicon substrate 100 having the plane orientation (111) is placed on stage 50 of texturing apparatus 10 illustrated in FIGS. 11A and 11B. The distance between nozzle 30 and silicon substrate 100 is set at 10 mm. The size of the substrate surface of silicon substrate 100 is 125 mm × 125 mm. The temperature of stage 50 is set at 25°C. The pressure in chamber 20 is set at 90 kPa. The entire surface of silicon substrate 100 is exposed to the etching gas by supplying the etching gas for 3.0 minutes from nozzle 30. The composition and supply amount of the etching gas is ClF₃/O₂/N₂ = 400/1,600/4,000 (sccm).

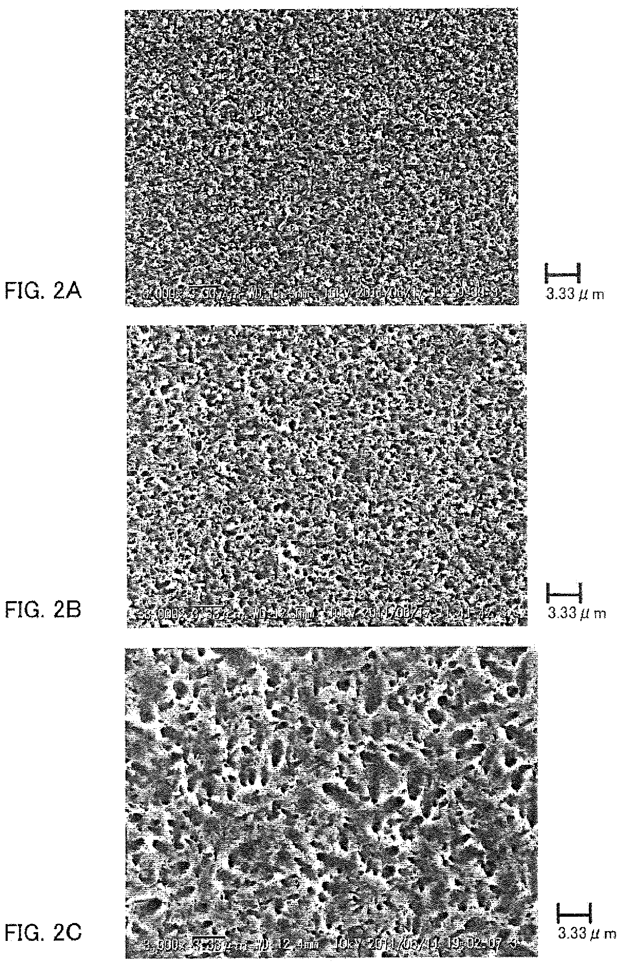

FIGS. 2A to 2C illustrate the surface during the process for forming the textured surface. FIG. 2A illustrates the surface of a silicon substrate when the surface of the silicon substrate is exposed to the etching gas for 10 seconds. FIG. 2B illustrates the surface of a silicon substrate when the surface of the silicon substrate is exposed to the etching gas for 30 seconds. FIG. 2C illustrates the surface of a silicon substrate when the surface of the silicon substrate is exposed to the etching gas for one minute. Fig. 2A illustrates a fine porous structure. FIG. 2B illustrates a moderate porous structure that has grown from the fine porous structure. FIG. 2C illustrates a coarse porous structure that has grown from the medium porous structure.

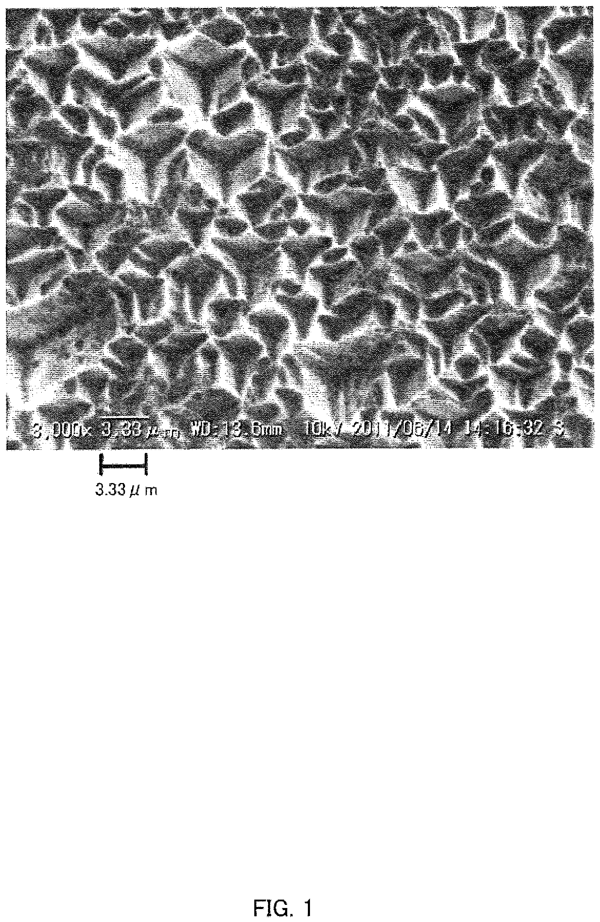

FIG. 1 illustrates the surface of the silicon substrate after the surface of the silicon substrate is exposed to the etching gas for three minutes. As illustrated in FIG 1, projections each having three faces (triangular pyramid-shaped projections) are densely formed on the textured surface of Example 1. The height h of the projections is 0.3 to 3.5 µm. The length of generatrix m of the projection is 0.6 to 6.0 µm. Note that, the height h and the length of generatrix m of the projection are calculated geometrically from an image of a plan view (upper view) of the textured surface by SEM (scanning electron microscope).

FIG. 1 and FIGS. 2A to 2C show that the projections each having three faces are formed after the porous structure is formed on the textured surface according to Example 1.

### [Example 2]

A silicon substrate having a textured surface is manufactured in the same manner as Example 1 except that the surface of the silicon substrate is exposed to the first etching gas and the second etching gas. The textured surface is formed by exposing the surface of the silicon substrate to the first etching gas for 45 seconds first, and subsequently exposing the surface of the silicon substrate to the second etching gas for 75 seconds. The composition and supply amount of the first etching gas is ClF₃/O₂/N₂ = 1,000/0/15,000 (sccm). The composition and supply amount of the second etching gas is ClF₃/O₂/N₂ = 1,000/3,500/15,000 (sccm). Note that, the time (45 seconds) for exposing the surface of the silicon substrate to the first etching gas is determined by experientially calculating the time for supplying the first etching gas for forming a good porous structure and a texture structure under the conditions described above.

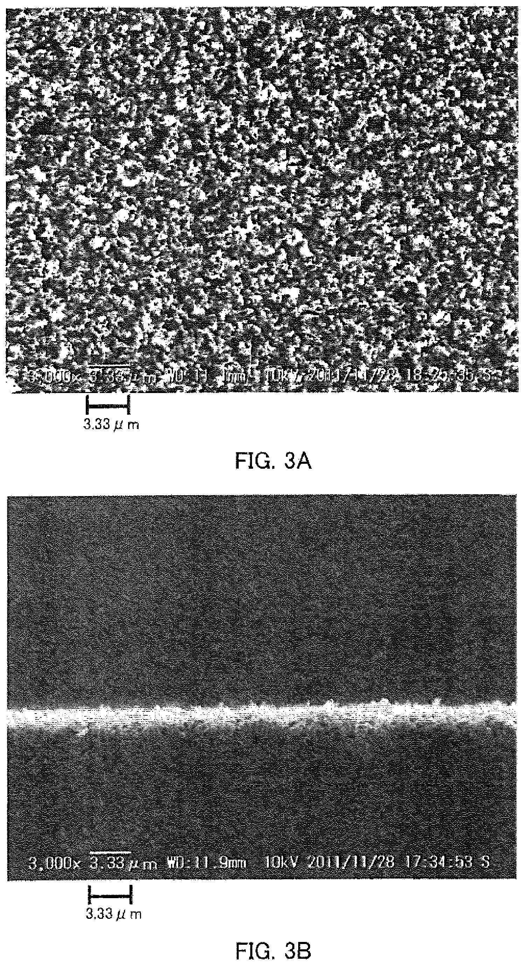

FIG. 3A illustrates a surface of the silicon substrate when the surface of the silicon substrate is exposed to the first etching gas for 45 seconds. FIG. 3B illustrates a cross section of the silicon substrate. FIG. 3A and FIG. 3B show that countless holes are formed on the surface of the silicon substrate by exposing the surface of the silicon substrate to the first etching gas, and the holes are extended irregularly toward the inside of the substrate (porous structure).

FIG. 4A illustrates a textured surface of the silicon substrate when the surface of the silicon substrate is exposed to the second etching gas for 75 second subsequent to the exposure of the surface of the silicon substrate to the first etching gas. FIG. 4B illustrates a cross section of the silicon substrate. FIG. 4A and FIG. 4B show that the textured surface including projections each having three faces is formed by further exposing the surface of the silicon substrate to the second etching gas. The height h of the projections on the textured surface is 0.5 to 5.0 µm. The length of generatrix m of the projection is 0.5 to 15 µm.

### [Comparative Example 1]

Except that the composition and supply amount of the etching gas are changed to "ClF₃/O₂/N₂ = 400/800/4,800 (sccm)", the same operation as Example 1 is performed. FIG. 5 illustrates a textured surface of the silicon substrate obtained. As illustrated in FIG. 5, a porous structure is formed on the textured surface in Comparative Example 1.

### [Comparative Example 2]

Except that the composition and the supply amount of the etching gas are changed to "ClF₃/O₂/N₂ = 400/2,400/3,200 (sccm)", the same operation as Example 1 are performed. FIG. 6 illustrates a textured surface of the silicon substrate obtained. As illustrated in FIG. 6, on the textured surface in Comparative Example 2, a plurality of fine triangular-pyramid projections are densely formed. The height h of the projection is 0.007 to 0.07 µm. The length of generatrix m of the projection m is 0.012 to 0.12 µm.

### [Comparative Example 3]

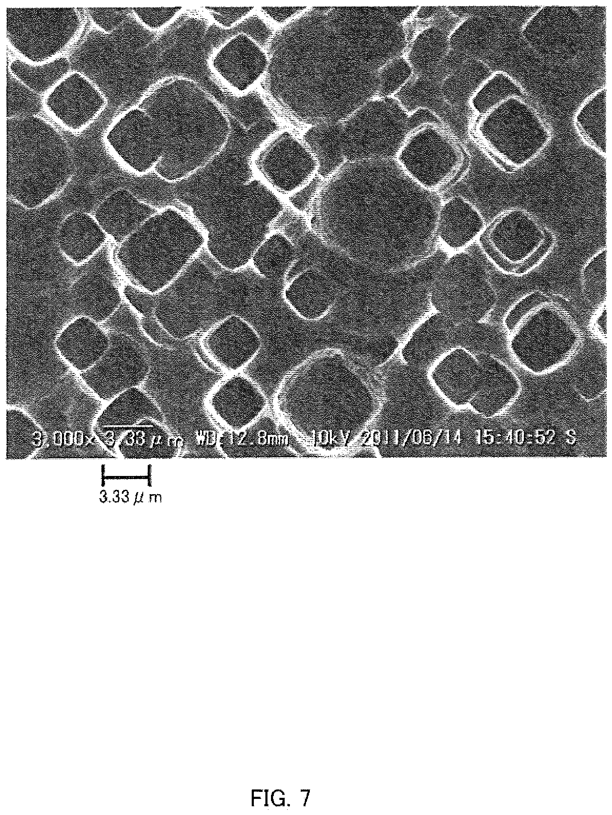

Except that the silicon substrate is replaced with a silicon substrate having a plane orientation (100), the same operation as Example 1 is performed. FIG. 7 illustrates a textured surface of the silicon substrate obtained. As illustrated in FIG. 7, on the textured surface in Comparative Example 3, a plurality of cavities and projections which are squares in cross section are densely formed.

### Industrial Applicability

A textured surface including projections having a specific shape and size is formed on a silicon substrate having a plane orientation (111) by dry etching. The silicon substrate has a low optical reflectance on the textured surface. Therefore, using the silicon substrate as a silicon substrate for a solar cell and using the textured surface as a light-receiving surface improve the photoelectric conversion rate of the solar cell.

### Reference Signs List

10 Texturing apparatus
20 Chamber
30, 40 Nozzle
31 Etching gas supply pipe
41 Gas supply pipe
50 Stage
100 Silicon substrate

## Claims

1. A method for manufacturing a silicon substrate, comprising:
a first step of providing a silicon substrate having a plane orientation (111); and
a second step of forming a textured surface by exposing a surface of the silicon substrate to an etching gas containing ClF₃ gas and O₂ gas, where a volume ratio of O₂ gas to ClF₃ gas (O₂/ClF₃) is greater than 2 and smaller than 6, the textured surface including a plurality of projections each having three faces, wherein the three faces are a (100) plane, a (010) plane, and a (001) plane.

2. The method for manufacturing the silicon substrate according to claim 1, wherein the surface of the silicon substrate is exposed to the etching gas under an atmospheric pressure.

3. The method for manufacturing the silicon substrate according to claims 1 or 2, wherein the second step includes:
exposing the surface of the silicon substrate to an etching gas having a volume ratio of O₂ gas to ClF₃ gas (O₂/ClF₃) greater than or equal to 0 and smaller than or equal to 4; and
forming the textured surface by exposing the surface of the silicon substrate to the etching gas having the volume ratio of O₂ gas to ClF₃ gas (O₂/ClF₃) greater than 2 and smaller than 6.

4. The method for manufacturing the silicon substrate according to claim 1, wherein:
a height of the projections is in a range greater than 1.5 µm and smaller than or equal to 10 µm.

## Patentansprüche

1. Verfahren zur Herstellung eines Siliziumsubstrats, umfassend:
einen ersten Schritt des Bereitstellens eines Siliziumsubstrats mit einer flachen Ausrichtung (111); und
einen zweiten Schritt des Bildens einer strukturierten Oberfläche durch Aussetzen einer Oberfläche des Siliziumsubstrats an ein ätzendes Gas, das ClF₃-Gas und O₂-Gas enthält, wobei ein Volumenverhältnis von O₂-Gas zu ClF₃-Gas (O₂/ClF₃) größer als 2 und kleiner als 6 ist, wobei die strukturierte Oberfläche eine Vielzahl von Vorsprüngen mit jeweils drei Seiten enthält, wobei die drei Seiten eine Ebene (100), eine Ebene (010) und eine Ebene (001) sind.

2. Verfahren zur Herstellung des Siliziumsubstrats nach Anspruch 1, wobei die Oberfläche des Siliziumsubstrats an das ätzende Gas unter Atmosphärendruck ausgesetzt wird.

3. Verfahren zur Herstellung des Siliziumsubstrats nach Anspruch 1 oder 2, wobei der zweite Schritt Folgendes umfasst:
Aussetzen der Oberfläche des Siliziumsubstrats an ein ätzendes Gas, das ein Volumenverhältnis von O₂-Gas zu ClF₃-Gas (O₂/ClF₃) von größer als oder gleich 0 und kleiner als oder gleich 4 hat; und
Bilden der strukturierten Oberfläche durch Aussetzen der Oberfläche des Siliziumsubstrats an das ätzende Gas, das das Volumenverhältnis von O₂-Gas zu ClF₃-Gas (O₂/ClF₃) von größer als 2 und kleiner als 6 aufweist.

4. Verfahren zur Herstellung des Siliziumsubstrats nach Anspruch 1, wobei:
eine Höhe der Vorsprünge in einem Bereich größer als 1,5 µm und kleiner als oder gleich 10 µm liegt.

## Revendications

1. Procédé de fabrication d'un substrat de silicium, comprenant :
une première étape de fourniture d'un substrat de silicium présentant une orientation plane (111) ; et
une deuxième étape de formation d'une surface texturée en exposant une surface du substrat de silicium à un gaz d'attaque contenant du gaz ClF₃ et du gaz O₂, où un rapport volumique du gaz O₂ au gaz ClF₃ (O₂/ClF₃) est supérieur à 2 et inférieur à 6, la surface texturée comprenant une pluralité de projections présentant chacune trois faces, lesdites trois faces étant un plan (100), un plan (010) et un plan (001).

2. Procédé de fabrication du substrat de silicium selon la revendication 1, dans lequel la surface du substrat de silicium est exposée au gaz d'attaque sous une pression atmosphérique.

3. Procédé de fabrication du substrat de silicium selon les revendications 1 ou 2, dans lequel la deuxième étape comprend :
l'exposition de la surface du substrat de silicium à un gaz d'attaque dont le rapport volumique du gaz O₂ au gaz ClF₃ (O₂/ClF₃) est supérieur ou égal à 0 et inférieur ou égal à 4 ; et
la formation de la surface texturée en exposant la surface du substrat de silicium au gaz d'attaque dont le rapport volumique du gaz O₂ au gaz ClF₃ (O₂/ClF₃) est supérieur à 2 et inférieur à 6.

4. Procédé de fabrication du substrat de silicium selon la revendication 1, dans lequel :
une hauteur des projections est située dans une plage supérieure à 1,5 µm et inférieure ou égale à 10 µm.
